**Europäisches Patentamt**

**European Patent Office**

**Office européen des brevets**

(11) Veröffentlichungsnummer: **0 107 004**
**B1**

(12) # EUROPÄISCHE PATENTSCHRIFT

(45) Veröffentlichungstag der Patentschrift:
04.02.87

(51) Int. Cl.⁴: **G 03 F 7/02**

(21) Anmeldenummer: **83109000.6**

(22) Anmeldetag: **12.09.83**

(54) Maske für die Korpuskularlithografie, Verfahren zu ihrer Herstellung und Verfahren zu ihrem Betrieb.

(30) Priorität: **22.09.82 DE 3235064**

(43) Veröffentlichungstag der Anmeldung:
**02.05.84 Patentblatt 84/18**

(45) Bekanntmachung des Hinweises auf die Patenterteilung:
**04.02.87 Patentblatt 87/6**

(84) Benannte Vertragsstaaten:
**DE FR GB NL**

(56) Entgegenhaltungen:
**US-A-3 056 073**
**US-A-3 356 864**
**US-A-3 445 733**

**ELECTRONICS, November 1981, New York R. WARD "Electron-beam projector suits up for submicrometer race"**
**VACUUM, Band 31, Nr. 7, 1981, Oxford R. HRACH "Modelling of electron emission from sandwich cathodes"**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft Berlin und München, Wittelsbacherplatz 2, D-8000 München 2 (DE)**

(72) Erfinder: **Lischke, Burkhard, Prof. Dr., In der Heuluss 13, D-8000 München 82 (DE)**

## Beschreibung

Die Erfindung betrifft eine Maske für die Korpuskularlithografie nach dem Oberbegriff des Anspruchs 1, ein Verfahren zu ihrer Herstellung und ein Verfahren zu ihrem Betrieb.

Beim Einsatz eines Elektronenprojektors für die Strukturerzeugung auf einem Halbleiterwafer sind die Belichtungszeiten sehr lang und deshalb die Kosten sehr hoch. Ein wirtschaftlicher Einsatz des Elektronenprojektors für die Massenproduktion von Strukturen auf z.B. Halbleitern (integrierte Schaltkreise) war daher bisher nicht möglich.

Bekannt ist der Einsatz des Elektronenprojektors für die Strukturerzeugung z.B. aus der Veröffentlichung von R. Ward in "Electronics', Nov. 3, 1981, 144 ff. Bei diesem bekannten Verfahren wird die bei lithografischen Verfahren zur Strukturerzeugung übliche Maske zusätzlich mit Cäsium-Jodid beschichtet, so daß bei Bestrahlung dieser Maske mit Licht in den transparenten Bereichen dieser Maske Fotoelektronen emittiert werden, die ihrerseits durch parallele elektrische und magnetische Felder auf den mit Fotolack beschichteten Halbleiterwafer zur Strukturerzeugung auf diesem Halbleiterwafer abgebildet werden. Die Belichtungszeit ist dabei durch den Quotienten aus Lackempfindlichkeit des auf den Halbleitarwafer aufgetragenen Fotolacks und aus der Kathodenstromdichte der auf der Maske sich befindlichen Fotokathode gegeben und liegt bei einer Kathodenstromdichte der auf der Maske sich befindlichen Fotokathode von beispielsweise $10^{-7}$ A/cm$^2$ und bei einer üblichen Lackempfindlichkeit des auf dem Halbleiterwafer angeordneten Fotolacks in der Größenordnung von 100 s.

Der vorliegenden Erfindung liegt die Aufgabe zugrunde, eine Maske für die Korpuskularlithografie der eingangs genannten Art anzugeben, die eine kürzere Belichtungszeit für die Strukturerzeugung auf Halblaiterwafern und deshalb eine Kostenreduzierung dieser Strukturerzeugung ermöglicht.

Diese Aufgabe wird erfindungsgemäß durch eine Maske nach dem Anspruch 1 gelöst. Mit einer erfindungsgemäßen Tunnelkathoden-Maske wird die Belichtungszeit für die Strukturerzeugung um fünf Größenordnungen reduziert. Der Durchsatz von zu strukturierenden Halbleiterwafern wird dann ausschließlich durch den Waferwechsel und die Justierung bestimmt. Danach ist ein Durchsatz von 1000 Stück 4 Zoll-Wafern mit Submikronstrukturen ohne weiteres möglich. Damit ist auch die Wirtschaftlichkeit eines solchen Verfahrens gesichert.

Eine erfindungsgemäße Tunnelkathodenmaske nutzt zur Auslösung der Elektronen den Feldeffekt aus und läßt Elektronenstromdichten von $10^{-2}$ A/cm$^2$ zu, so daß die Belichtungszeit wirksam auf $10^{-3}$ s verringert wird.

Ausgestaltungen und Vorteile der Erfindung sind in den abhängingen Ansprüchen, der Beschreibung und der Zeichnung dargestellt. Ausführungsbeispiele der Erfindung werden anhand der Zeichnung im folgenden näher beschrieben.

Fig.1 mit 3 erläutern ein theoretisches Modell für die Feldemission aus Tunnelkathoden.

Fig.4 und 5 zeigen schematisch erfindungsgemäße Tunnelkathodenmasken für die Korpuskularlithografie

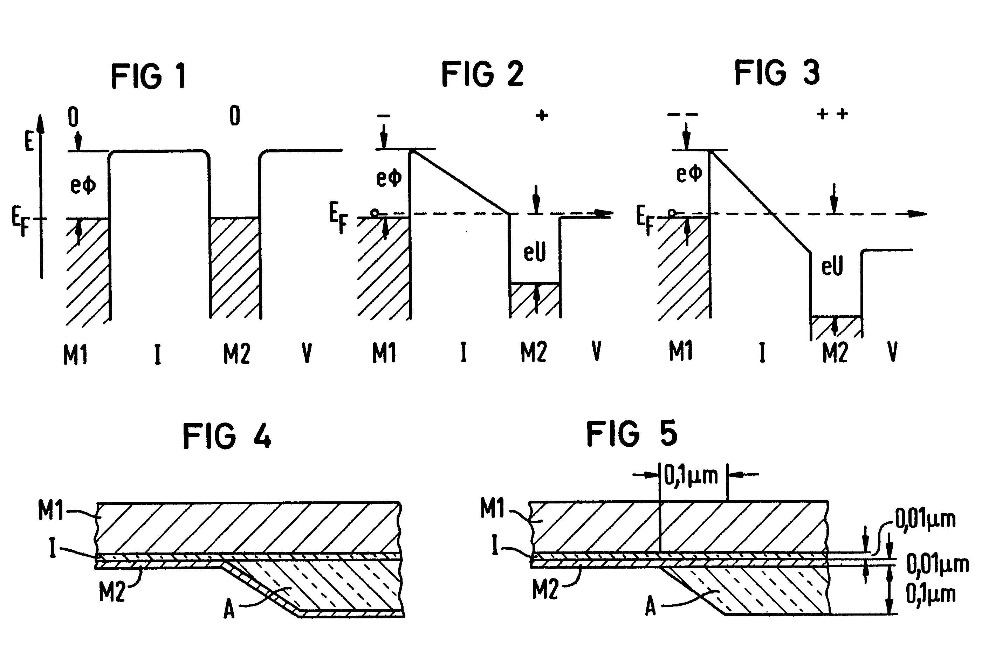

Die Fig.1 mit 3 erläutern schematisch ein theoretisches Modell für die Feldemission aus Tunnelkathoden. Dieses theoretische Modell ist von R. Hrach in "Vacuum', Vol.31, No.7, 1981, Seite 297 ff. beschrieben worden.

Fig.1 zeigt eine Sandwich-Kathode, welche aus einem Metall M1, einem Isolator I und einem weiteren Metall M2 besteht. Das Metall M2 grenzt an das Vakuum V an. Sowohl das Metall M1 als auch das Metall M2 befindet sich in Fig.1 auf dem Potential Null. Die Energiebänder sowohl des Metalls M1 als auch des Metalls M2 sind jeweils bis zur Fermi-Kante $E_F$ mit Elektronen voll besetzt. Ein Elektron, welches in einem Metall M1, M2 in Fig.1 die Fermi-Energie $E_F$ besitzt, müßte eine Energie in Höhe der Austrittsarbeit e Ø (mit e: Elementarladung) zugeführt bekommen, um einen ungebundenen Energiezustand einnehmen zu können und sich somit vom Metall M1, M2 fortbewegen zu können.

In Fig.2 ist eine Spannung an die Sandwich-Kathode von Fig.1 angelegt worden, die in ihrer Größe dem Austrittspotential Ø entspricht. Dabei ist die negative Spannung an das Metall M1 und die positive Spannung an das Metall M2 angelegt. Ein Elektron, welches sich im Metall M1 befindet und gerade eine Energie gleich der Fermi-Energie $E_F$ besitzt, könnte dabei gerade durch den Potentialberg zwischen negativer Metallelektrode M1 und dem Dielektrikum das durch den Isolator I repräsentiert wird, tunneln. Ein solches Elektron müßte dann jedoch auch noch die positive Elektrode M2 durchdringen.

Wird eine Spannung U wie in Fig.3 an die Sandwich-Kathode von Fig.1 angelegt, die das Austrittspotential Ø überschreitet, so tunneln Elektronen durch den Potentialberg zwischen der negativen Metallelektrode M1 und dem Dielektrikum I, werden dann durch das elektrische Feld im Dielektrikum beschleunigt, so daß einige der Elektronen die dünne, positive Elektrode M2 durchdringen können und in das Vakuum V austreten. Die Stromdichte durch Feldemission wird durch die Fowler-Nordheim-Gleichung beschrieben, die in Lehrbüchern über Physik zu finden ist, und hängt von der elektrischen Feldstärke sowie vom Austrittspotential Ø ab.

Die Fig.4 und 5 zeigen schematisch erfindungsgemäße Tunnelkathoden-Masken für die Elektronenlithografie. Eine erfindungsgemäße Maske für die Elektronenlithografie ist aus einer Tunnelkathode auf gebaut. In den nicht Elektronen emittierenden Bereichen einer erfindungsgemäßen Maske ist ein Absorber A aufgebracht, der entweder wegen des größeren Elektrodenabstandes zwischen den Metallen M1 und M2 eine Feldemisaion in diesen nicht Elektronen emittierenden Bereichen vermeidet oder der die in den Absorber A emittierten Elektronen wegen seiner entsprechend großen Dicke absorbiert.

Ein Aufbau einer erfindungsgemäßen Kathodenmaske ist möglich durch folgende Anordnungen oder durch eine Kombination aus folgenden Anordnungen:

a) Metall-Isolator-Metall; Beispiel: Aluminium-10 nm Aluminiumoxid $Al_2O_3$-10 nm Gold;

b) dotierter Halbleiter-Dielektrikum-Metall; Beispiel n-Silizium-10 nm Siliziumdioxid $SiO_2$-10 nm Aluminium;

c) Metall-Isolator-Supraleiter; Beispiel: Aluminium-10 nm Aluminiumoxid $Al_2O_3$-Niob Nb.

Der Absorber A kann aus einem Metall oder aus einem Dielektrikum oder aus einer Kombination von solchen Materialien bestehen: Beispielsweise kann der Absorber A Gold, Chrom, Kohlenstoff, Fotolack aufweisen.

Eine erfindungsgemäße Maske kann wie üblich fotolithografisch oder elektronenlithografisch oder durch Bestrahlung der zu bildenden Absorberbereiche mit Elektronen hergestellt werden, wobei in letzterem Fall sich diese Absorberbereiche durch Kontamination von Kohlenstoff ausbilden (siehe A. Broers in DE-A-28 40 553).

Wird die gesamte Oberfläche einer erfindungsgemäßen Kathodenmaske durch Metall gebildet, so ist eine Reinigung dieser Maske durch selektives Plasmaätzen leicht möglich. Werden Justiermarken auf einer erfindungsgemäßen Kathodenmaske von den Metallen M1, M2 elektrisch getrennt ausgeführt, so genügt das Anlegen einer Spannung U von z.B. 10 Volt an die beiden Metallelektroden M1, M2, die einen Abstand von 10 nm aufweisen, um ein elektrisches Feld zwischen diesen beiden Metallelektroden M1, M2 von $10^7$V/cm aufzubauen und damit Feldemission auszulösen. Die aus einer erfindungsgemäßen Kathodenmaske austretenden Elektronen werden zur Justierung benutzt. Nach dieser Justierung wird an die elektrisch gegen die Marken isolierte Maske (diese Isolation kann z.B. durch eine Laser-Fräse erfolgen) eine Spannung U angelegt, um Feldemission und damit den Belichtungsschritt auszulösen

Ein Elektronenprojektor in dem eine erfindungsgemäße Kathodenmaske eingesetzt werden kann, ist aus der obengenannten Veröffentlichung von R. Ward bekannt.

Der Absorber A in der Fig.3 weist eine Dicke von 100 nm auf. Diese Dicke von 100 nm erreicht der Absorber A am Übergang zwischen einem Elektronen emittierenden Bereich und einem nicht Elektronen emittierenden Bereich in einem Übergangsbereich von etwa 100 nm. Bei der Tunnelkathoden-Maske von Fig.5 ist der Absorber A in einem nicht Elektronen emittierenden Bereich auf das Metall M2 aufgebracht. Bei der Tunnelkathoden-Maske von Fig.4 ist der Absorber A auf den Isolator Z und das Metall M2 seinerseits auf diesen Absorber A aufgebracht. In Fig.4 wird in dem nicht Elektronen emittierenden Bereich wegen des größeren Elektrodenabstands zwischen dem Metall M1 und dem Metall M2 eine Feldemission vermieden. In Fig.3 werden die emittierten Elektronen, die den Potentialberg zwischen dem Metall M1 und dem Isolator I durchtunnelt und das Metall M2 durchdrungen haben, in dem Absorber A absorbiert.

## Patentansprüche

1. Maske für die Korpuskularlithografie, <u>gekennzeichnet</u> durch eine Tunnelkathode in den korpuskel-emittierenden Bereichen und einen absorber (A) in nicht-korpuskel-emittierenden Bereichen.

2. Maske nach Anspruch 1, <u>gekennzeichnet</u> durch einen Aufbau Metall (M1)-Isolator (I)-Metall (M2) in korpuskel-emittierenden Bereichen.

3. Maske nach einem der Ansprüche 1 bis 2, <u>gekennzeichnet</u> durch einen Aufbau dotierter Halbleiter-Dielektrikum-Metall in korpuskel-emittierenden Bereichen.

4. Maske nach einem der Ansprüche 1 bis 3, <u>gekennzeichnet</u> durch einen Aufbau Metall-Isolator-Supraleiter in korpuskel-emittierenden Bereichen.

5. Maske nach einem der Ansprüche 1 bis 4, dadurch <u>gekennzeichnet</u>, daß mindestens ein Absorberbereich (A) aus einem Metall besteht.

6. Maske nach einem der Ansprüche 1 bis 5, dadurch <u>gekennzeichnet</u>, daß mindestens ein Absorberbereich (A) aus einem Dielektrikum besteht.

7. Verfahren zur Herstellung einer Maske nach Anspruch 1 bis 6, dadurch <u>gekennzeichnet</u>, daß zu bildende Absorberbereiche (A) mit Elektronen bestrahlt werden, wobei sich diese Absorberbereiche (A) durch Kontamination von Kohlenstoff ausbilden.

9. Verfahren zum Betrieb einer Maske nach einem der Ansprüche 1 bis 8, dadurch <u>gekennzeichnet</u>, daß die austretenden Elektronen zur Justierung der Maske benutzt werden.

## Claims

1. A mask for corpuscular lithography, <u>characterised by</u> a tunnel cathode in the particle-emitting regions and by an absorber (A) in regions which do not emit particles.

2. A mask according to Claim 1, <u>characterised by</u> a metal (M1)-insulator (I) - metal (M2) structure in the particle-emitting regions.

3. A mask according to one of Claims 1 to 2, <u>characterised by</u> a doped semiconductor-dielectric-metal structure in the particle-emitting regions.

4. A mask according to one of Claims 1 to 3, characterised by a metal - insulator - superconductor structure in the particle-emitting regions.

5. A mask according to one of Claims 1 to 4, characterised in that at least one absorber region (A) consists of a metal.

6. A mask according to one of Claims 1 to 5, characterised in that at least one absorber region (A) consists of a dielectric.

7. A process for the production of a mask according to Claim 1 to 6, characterised in that absorber regions (A) to be formed are irradiated with electrons, said absorber regions (A) being formed by contamination with carbon.

8. A process for operating a mask according to one of Claims 1 to 6, characterised in that emerging electrons are used to adjust the mask.

**Revendications**

1. Masque pour la lithographie corpusculaire, caractérisé par une cathode à effet tunnel dans les régions émettant des corpuscules, et par un absorbeur (A) dans des régions n'émettant pas de corpuscules.

2. Masque suivant la revendication 1, caractérisé par une structure métal (M1)-isolant (I)-métal (M2) dans des zones émettant les corpuscules.

3. Masque suivant l'une des revendications 1 à 2, caractérisé par une structure semiconducteur dopédiélectrique-métal dans des zones émettant des corpuscules.

4. Masque suivant l'une des revendications 1 à 3, caractérisé par une structure métal-isolant-supraconducteur dans des zones émettant des corpuscules.

5. Masque suivant l'une des revendications 1 à 4, caractérisé par le fait qu'au moins une zone formant absorbeur (A) est constituée par un métal.

6. Masque suivant l'une des revendications 1 à 5, caractérisé par le fait qu'au moins une zone formant absorbeur (A) est constituée par un diélectrique.

7. Procédé pour fabriquer un masque suivant les revendications 1 à 6, caractérisé par le fait que des zones formant absorbeurs (A) devant être formées sont irradiées par des électrons, ces zones formant absorbeurs (A) se formant par contamination du carbone.

8. Procédé pour fabriquer un masque suivant l'une des revendications 1 à 6, caractérisé par le fait que l'on utilise des électrons sortants, pour ajuster le masque.

FIG 1

FIG 2

FIG 3

FIG 4

FIG 5

$E$

$E_F$

$E_F$

$E_F$

$e\Phi$

$e\Phi$

$e\Phi$

$eU$

$eU$

M1   I   M2   V

M1   I   M2   V

M1   I   M2   V

0        0

—   +

—        ++

M1

I

M2

A

M1

I

M2

A

0,01 μm

0,01 μm

0,1 μm

0,1 μm